# DEMANDE DE BREVET EUROPEEN

(11) **EP 4 125 210 A1**
(43) Date de publication de la demande: **01.02.2023**
(21) Numéro de dépôt: 22186768.2
(22) Date de dépôt: 25.07.2022
(51) Int. Cl.: H03F 3/181, G10H 1/00

(54) **PRÉAMPLIFICATEUR AUDIO À CARTOUCHE INTERCHANGEABLE POUR MICROPHONE ET KIT LE COMPRENANT**

(30) Priorité: 26.07.2021 FR 2108063
(71) Demandeur: Eldora Productions, 03370 Courcais (FR)
(72) Inventeur: CHAUVET, Guillaume, 03370 Chazemais (FR)
(74) Mandataire: Cabinet Chaillot

(57) **Abrégé**

L'invention concerne un préamplificateur audio (1) pour microphone, comprenant : un châssis (2) comprenant au moins une entrée audio (17) et au moins une sortie audio, un panneau de commande (3) comportant un sélecteur de gain (10) étant disposé sur l'une des faces du châssis (2), le châssis (2) possédant en outre un volume d'accueil à l'intérieur duquel est disposé un premier connecteur ; et une cartouche (6) comprenant un circuit de préamplification et un circuit de réglage de gain, la cartouche (6) possédant en outre un second connecteur complémentaire du premier connecteur, la cartouche (6) étant configurée pour être insérée de manière amovible dans le volume d'accueil du châssis (2) de manière à connecter les premier et second connecteurs. L'invention concerne également un kit de préamplification audio comprenant un préamplificateur audio (1) et plusieurs cartouches supplémentaires.

## Description

La présente invention concerne le domaine des préamplificateurs audio, et porte en particulier sur un préamplificateur audio à cartouche interchangeable pour microphone et sur un kit de préamplification le comprenant. Les préamplificateurs audio sont des amplificateurs électroniques qui permettent de préalablement amplifier et adapter un signal audio avant de le transmettre à un amplificateur principal.

Les préamplificateurs audio pour microphone sont indispensables lors d'enregistrements audio à l'aide de microphones. Ils ont, en effet, pour fonction de préamplifier les signaux de faible amplitude (qui sont très sensibles au bruit) émis par les microphones.

Les préamplificateurs audio traditionnels comprennent généralement un châssis mécanique dans lequel est installé de manière fixe un module électronique comprenant un circuit de préamplification. Chaque préamplificateur audio traditionnel produit ainsi un son qui dépend de sa conception électronique.

Les ingénieurs du son désirant essayer plusieurs types de sons sont donc obligés d'utiliser plusieurs préamplificateurs audio avec plusieurs châssis mécaniques, ce qui nécessite d'acheter plusieurs appareils et de débrancher et rebrancher à chaque fois la connectique lors du changement du préamplificateur audio.

Les préamplificateurs audio traditionnels, qui existent depuis les années 1920, ont ainsi chacun un circuit de préamplification spécifique d'une certaine technologie. A l'heure actuelle, il n'existe pas sur le marché un système générique avec un seul sélecteur de gain pouvant piloter plusieurs technologies de préamplificateurs (par exemple, à lampe, à amplificateur opérationnel, à transistor classe A, etc.). Les préamplificateurs audio sont définis par un gain et, d'un point de vue électronique, celui-ci change suivant un rapport résistif de potentiomètre. Pour que l'augmentation du gain soit linéaire à l'oreille humaine, ce rapport résistif est défini par une fonction (linéaire, logarithmique, anti logarithmique, etc.) suivant la conception du préamplificateur. En outre, la valeur résistive maximale est aussi différente suivant les technologies de préamplificateurs. Ainsi, il n'aurait pas été naturel, ni évident pour l'homme du métier, à savoir un électronicien, de piloter avec un seul sélecteur de gain plusieurs préamplificateurs différents ayant des technologies différentes, étant donné que chaque circuit de préamplification possède un rapport résistif qui lui est propre.

La demande de brevet américain US2017/124997A1 divulgue un système d'instrument de musique électronique permettant d'influencer le son d'un instrument de musique électrique, ledit système ayant un boîtier contenant une électronique de commande avec des fentes associées pour recevoir des modules d'effets, les modules d'effets possédant des potentiomètres sur ceux-ci afin de permettre leur réglage. Ainsi, lorsque le module d'effets est un module préamplificateur, le sélecteur de gain (c'est-à-dire, les potentiomètres) est disposé directement sur le module préamplificateur, de telle sorte que chaque module préamplificateur doit avoir son propre sélecteur de gain monté sur celui-ci. En outre, les éléments de commande présents sur le boîtier du système ont uniquement une fonction de routage entrée/sortie, c'est_à-dire qu'ils permettent uniquement d'activer un ou plusieurs modules d'effets mais qu'ils ne permettent pas d'effectuer une sélection de gain dans un module préamplificateur. Ainsi, le système du document US2017/124997A1 n'est pas un système générique permettant de piloter plusieurs technologies de préamplificateurs avec un seul sélecteur de gain.

La présente invention vise à résoudre les inconvénients de l'état antérieur de la technique, en proposant un préamplificateur audio pour microphone possédant une cartouche amovible incorporant le circuit de préamplification, de telle sorte que la fonction de préamplification est déportée dans la cartouche, ce qui permet de facilement changer le circuit de préamplification, sans avoir à changer le châssis du préamplificateur audio, et sans avoir à débrancher puis rebrancher la connectique reliée au châssis.

La présente invention a donc pour objet un préamplificateur audio pour microphone, caractérisé par le fait qu'il comprend : un châssis dans lequel est disposé un premier module électronique, le châssis comprenant au moins une entrée audio et au moins une sortie audio reliées au premier module électronique, un panneau de commande comportant un sélecteur de gain étant disposé sur l'une des faces du châssis et relié au premier module électronique, le châssis possédant en outre un volume d'accueil à l'intérieur duquel est disposé un premier connecteur relié au premier module électronique, le panneau de commande possédant une ouverture depuis laquelle débouche le volume d'accueil ; et une cartouche dans laquelle est disposé un second module électronique comprenant un circuit de préamplification et un circuit de réglage de gain, la cartouche possédant en outre un second connecteur complémentaire du premier connecteur, ledit second connecteur étant relié au second module électronique, la cartouche étant configurée pour être insérée de manière amovible dans le volume d'accueil du châssis par l'intermédiaire de l'ouverture de manière à connecter les premier et second connecteurs l'un à l'autre ; dans lequel, lorsque la cartouche est insérée dans le volume d'accueil du châssis et que les premier et second connecteurs sont connectés ensemble, le premier module électronique est configuré pour transmettre un signal audio d'entrée, provenant de l'au moins une entrée audio, au circuit de préamplification de la cartouche et un signal de sélection de gain, provenant du sélecteur de gain, au circuit de réglage de gain de la cartouche, le circuit de réglage de gain est configuré pour régler le gain du circuit de préamplification en fonction du signal de sélection de gain, et le circuit de préamplification est configuré pour préamplifier le signal audio d'entrée et transmettre le signal audio préamplifié au premier module électronique qui est configuré pour le transmettre ensuite à l'au moins une sortie audio.

De préférence, le panneau de commande est disposé en face avant du châssis, et possède une ouverture depuis laquelle débouche le volume d'accueil, le panneau de commande étant relié au premier module électronique à l'aide d'une ou plusieurs nappes de liaison.

Le volume d'accueil du châssis permet ainsi d'accueillir et de brancher rapidement différents types de circuits de préamplification sous forme de cartouches.

Le châssis du préamplificateur audio est générique et regroupe l'environnement électronique commun à tous les préamplificateurs audio (par exemple, entrée/sortie, alimentation, vumètre, boutons de volume, etc.). En revanche, la partie électronique de la fonction de préamplification est déportée dans la cartouche distincte du châssis et interchangeable.

Le préamplificateur audio selon la présente invention permet ainsi d'utiliser plusieurs types et technologies de circuits de préamplification pour microphone avec un seul sélecteur de gain générique disposé sur le panneau de commande du châssis, le sélecteur de gain permettant de régler, par l'intermédiaire du circuit de réglage de gain de la cartouche, le gain du circuit de préamplification de la cartouche installée dans le volume d'accueil du châssis. La présente invention a donc les avantages suivants :
- intérêt économique pour l'utilisateur : possibilité d'avoir plusieurs circuits de préamplification différents sans avoir à racheter l'environnement commun à tous les préamplificateurs (par exemple, châssis, alimentation, sélecteur de gain, vumètre, etc.) ; et
- gain de temps pour l'utilisateur : possibilité de tester plusieurs types de sons en changeant rapidement la cartouche et sans avoir à débrancher/rebrancher les câbles d'entrée/sortie d'un périphérique à un autre.

Les premier et second connecteurs complémentaires peuvent, par exemple, être des connecteurs de type connecteur bord de carte.

Le préamplificateur audio pour microphone selon la présente invention est, par exemple, destiné aux ingénieurs du son, aux preneurs de son ou aux techniciens audiovisuels.

Selon une caractéristique particulière de l'invention, le circuit de réglage de gain comprend un réseau de résistances relié au circuit de préamplification et un réseau de commutateurs analogiques ou relais reliés au réseau de résistances et configurés pour être pilotés par le signal de sélection de gain de manière à changer la valeur ohmique du réseau de résistances en fonction du signal de sélection de gain.

Avantageusement, le circuit de préamplification de la cartouche comprend au moins un transistor de puissance configuré pour amplifier le signal audio reçu et un circuit de gain (comprenant des résistances) relié à l'au moins un transistor de puissance et permettant de définir le gain de l'au moins un transistor de puissance.

Le signal de sélection de gain provenant du sélecteur de gain permet de piloter l'ouverture ou la fermeture de chacun des commutateurs analogiques ou relais de manière à définir une valeur ohmique spécifique du réseau de résistances en fonction de la position du sélecteur de gain. Le réseau de résistances du circuit de réglage de gain est relié au circuit de gain du circuit de préamplification et permet, selon la valeur ohmique du réseau de résistances définie par la position du sélecteur de gain, de modifier le gain du transistor de puissance. Dans l'état de la technique, chaque conception de préamplificateur a une courbe unique de gain définie par la valeur ohmique d'un potentiomètre pouvant avoir une valeur en ohm différente (par exemple, 1k, 10k, 100k, etc.) et une courbe différente (par exemple, linéaire, logarithmique, anti logarithmique, etc.). Comme indiqué précédemment, les préamplificateurs audio sont définis par un gain et, d'un point de vue électronique, celui-ci change suivant un rapport résistif. Pour que l'augmentation du gain soit linéaire à l'oreille humaine, ce rapport résistif peut être défini par une fonction (linéaire, logarithmique ou anti logarithmique, etc.) suivant la conception du préamplificateur. En plus de la forme de la courbe, la valeur résistive maximale doit également être déterminée, qui est aussi différente suivant la technologie de préamplificateurs (par exemple, lampe, amplificateur opérationnel (AOP), transistor classe A, etc.).

Dans la présente invention, la courbe résistive est remplacée et reconstituée à l'aide du réseau de résistances et du réseau de commutateurs analogiques ou relais pilotés par le sélecteur de gain.

En pratique, pour chaque préamplificateur audio existant, la courbe du potentiomètre est reconstituée en prélevant différentes valeurs ohmiques correspondant à l'ensemble des positions possibles du sélecteur de gain. L'agencement du réseau de résistances et du réseau de commutateurs analogiques ou relais dans le circuit de réglage de gain de la cartouche est ensuite choisi pour reproduire les valeurs ohmiques prélevées selon la position du sélecteur de gain. Dans la présente invention, le signal basse fréquence (BF) reste ainsi sur la cartouche.

La présente invention permet ainsi d'avoir un châssis ou rack générique dont le panneau de commande peut commander n'importe quelle conception électronique de circuits de préamplification et de conserver le signal BF de faible amplitude sur la cartouche.

Selon une caractéristique particulière de l'invention, le sélecteur de gain est un commutateur à douze positions, les douze positions correspondant à douze valeurs ohmiques différentes du réseau de résistances du circuit de réglage de gain.

Le sélecteur de gain est ainsi un potentiomètre.

Les douze positions du sélecteur de gain peuvent, par exemple, correspondre aux gains suivants pour le circuit de préamplification : 0, 6, 12, 18, 24, 30, 36, 42, 48, 54, 60 et 66 dB.

Selon une caractéristique particulière de l'invention, le second module électronique de la cartouche comprend en outre, en aval du circuit de préamplification, un circuit de désymétrisation et un circuit de symétrisation.

Ainsi, le circuit de désymétrisation permet de désymétriser le signal audio préamplifié à la sortie du circuit de préamplification, puis le circuit de symétrisation permet de resymétriser le signal audio préamplifié avant de le transmettre à l'au moins une sortie audio. Avantageusement, la sortie du circuit de désymétrisation est reliée au premier module électronique du châssis par l'intermédiaire des premier et second connecteurs en vue d'un traitement par le premier module électronique, puis le signal ainsi traité est retransmis au circuit de symétrisation dont la sortie est reliée à l'au moins une sortie audio par l'intermédiaire des premier et second connecteurs puis du premier module électronique.

Selon une caractéristique particulière de l'invention, la cartouche est métallique de manière à servir de cage de Faraday.

Ainsi, la présence du signal BF dans la cartouche de type cage de Faraday permet d'obtenir un résultat de compatibilité électromagnétique (CEM) optimal.

Selon une caractéristique particulière de l'invention, l'au moins une entrée audio et l'au moins une sortie audio sont d'au moins un type parmi jack et XLR.

Un connecteur de type jack comprend un pôle + et une masse et permet la transmission d'un signal dit asymétrique, tandis qu'un connecteur de type XLR comprend un pôle +, un pôle - et une masse et permet la transmission d'un signal dit symétrique.

De préférence, le châssis comprend une entrée audio de type jack et une entrée audio de type XLR (avec commutation automatique jack/XLR par le premier module électronique), ainsi qu'une sortie audio de type XLR.

Avantageusement, lorsqu'un signal audio est transmis sur une entrée audio de type jack, le signal audio est d'abord symétrisé par le premier module électronique avant d'être transmis au circuit de préamplification.

Selon une caractéristique particulière de l'invention, le panneau de commande comprend en outre un vumètre relié au premier module électronique.

Ainsi, le vumètre permet d'indiquer visuellement, par exemple à l'aide de différentes diodes électroluminescentes (DEL), le niveau sonore du signal audio de sortie.

Selon une caractéristique particulière de l'invention, le châssis comprend en outre une entrée d'alimentation électrique reliée au premier module électronique et au premier connecteur par l'intermédiaire d'un interrupteur marche/arrêt disposé sur le panneau de commande. Avantageusement, l'entrée d'alimentation électrique est de type 115/230VAC, 50/60Hz, et est reliée à une alimentation AC/AC et AC/DC 48VDC, +/-12VDC, 36VAC, disposée dans le châssis, ce qui permet d'alimenter en puissance les différents circuits électroniques du préamplificateur audio.

L'interrupteur marche/arrêt permet à l'utilisateur d'activer ou d'arrêter l'alimentation du préamplificateur audio.

Selon une caractéristique particulière de l'invention, le premier module électronique comprend un circuit de réglage de puissance de sortie configuré pour régler la puissance de sortie du signal audio préamplifié en fonction d'un signal de sélection de puissance de sortie provenant d'un sélecteur de puissance de sortie disposé sur le panneau de commande.

Le sélecteur de puissance de sortie permet ainsi de choisir le niveau sonore du signal audio à la sortie du préamplificateur audio.

Avantageusement, lorsque les premier et second connecteurs sont connectés, l'entrée du circuit de réglage de puissance de sortie du châssis correspond à la sortie du circuit de désymétrisation de la cartouche, et la sortie du circuit de réglage de puissance de sortie du châssis correspond à l'entrée du circuit de symétrisation de la cartouche. Avantageusement, le circuit de réglage de puissance de sortie possède également un circuit d'adaptation d'impédance.

Avantageusement, un interrupteur est relié au vumètre pour choisir si le vumètre représente visuellement le niveau sonore avant ou après passage du signal audio préamplifié dans le circuit de réglage de puissance de sortie.

Selon une caractéristique particulière de l'invention, le circuit de réglage de puissance de sortie comprend en outre un filtre passe-haut configuré pour être activé par un commutateur d'activation de filtre passe-haut disposé sur le panneau de commande.

Ainsi, le commutateur d'activation de filtre passe-haut permet à l'utilisateur d'actionner ou non le filtre passe-haut. Le commutateur d'activation de filtre passe-haut peut, par exemple, avoir trois positions possibles : Fréquence de coupure de 80Hz ; Arrêt ; et Fréquence de coupure de 120Hz.

Le filtre passe-haut peut, par exemple, être un filtre actif passe-haut (ou « low cut » en anglais) avec une pente de -12 dB/octave.

Selon une caractéristique particulière de l'invention, le premier module électronique comprend un circuit d'alimentation fantôme 48V en aval d'une entrée audio de type XLR, ledit circuit d'alimentation fantôme 48V étant configuré pour être actionné par un commutateur d'activation d'alimentation fantôme 48V disposé sur le panneau de commande.

Le circuit d'alimentation fantôme 48V permet de brancher sur l'entrée audio de type XLR symétrique un microphone qui a besoin de courant électrique pour fonctionner.

De préférence, un voyant lumineux est disposé sur le panneau de commande pour indiquer l'état du commutateur d'activation d'alimentation fantôme 48V.

Selon une caractéristique particulière de l'invention, le premier module électronique comprend un circuit d'inversion de phase disposé entre l'au moins une entrée audio et le premier connecteur, ledit circuit d'inversion de phase étant configuré pour être activé par un commutateur d'activation d'inversion de phase disposé sur le panneau de commande.

Ainsi, le circuit d'inversion de phase permet d'inverser la phase du signal audio d'entrée lorsque le commutateur d'activation d'inversion de phase est actionné.

De préférence, un voyant lumineux est disposé sur le panneau de commande pour indiquer l'état du commutateur d'activation d'inversion de phase.

Avantageusement, une entrée audio de type jack et une entrée audio de type XLR sont reliées au circuit d'inversion de phase, et le circuit d'inversion de phase intègre un filtre de compatibilité électromagnétique (CEM). Selon une caractéristique particulière de l'invention, le premier module électronique comprend un circuit de bloc d'atténuation -20dB disposé entre l'au moins une entrée audio et le premier connecteur, ledit circuit de bloc d'atténuation -20dB étant configuré pour être activé par un commutateur d'activation de bloc d'atténuation -20dB disposé sur le panneau de commande.

Ainsi, le circuit de bloc d'atténuation -20dB, également appelé PAD (pour « Passive Attenuation Device » en anglais) 0/-20 dB, permet d'atténuer le signal audio d'entrée de - 20dB (avant transmission au circuit de préamplification) lorsque le commutateur d'activation de bloc d'atténuation - 20dB est actionné.

De préférence, un voyant lumineux est disposé sur le panneau de commande pour indiquer l'état du commutateur d'activation de bloc d'atténuation -20dB.

La présente invention a également pour objet un kit de préamplification audio comprenant un préamplificateur audio tel que décrit ci-dessus et plusieurs cartouches supplémentaires, chaque cartouche supplémentaire comprenant un circuit de préamplification et un circuit de réglage de gain reliés à un second connecteur complémentaire du premier connecteur du châssis du préamplificateur audio, chaque cartouche supplémentaire étant configurée pour être insérée seule et de manière amovible dans le volume d'accueil du châssis de manière à connecter les premier et second connecteurs l'un à l'autre, dans lequel deux cartouches quelconques parmi la cartouche du préamplificateur audio et les cartouches supplémentaires ont au moins l'un parmi des circuits de préamplification différents et des circuits de réglage de gain différents. Ainsi, le volume d'accueil du châssis du kit de préamplification audio selon la présente invention permet l'insertion d'une seule cartouche choisie en fonction de la préamplification souhaitée.

La fonction de préamplification du kit peut ainsi être facilement et rapidement changée en retirant la cartouche actuellement branchée et en la remplaçant par une autre cartouche du kit ayant une fonction de préamplification appropriée.

Pour mieux illustrer l'objet de la présente invention, on va en décrire ci-après, à titre illustratif et non limitatif, un mode de réalisation préféré, avec référence aux dessins annexés.

Sur ces dessins :
[Fig. 1] est une vue en perspective d'un préamplificateur audio pour microphone selon la présente invention ;
[Fig. 2] est une vue de face du préamplificateur audio, sans sa cartouche ;
[Fig. 3] est une vue en coupe partielle du préamplificateur audio, au niveau de sa cartouche ;
[Fig. 4] est un schéma de principe du préamplificateur audio ; et
[Fig. 5] est un schéma électronique à titre d'exemple de la cartouche du préamplificateur audio.

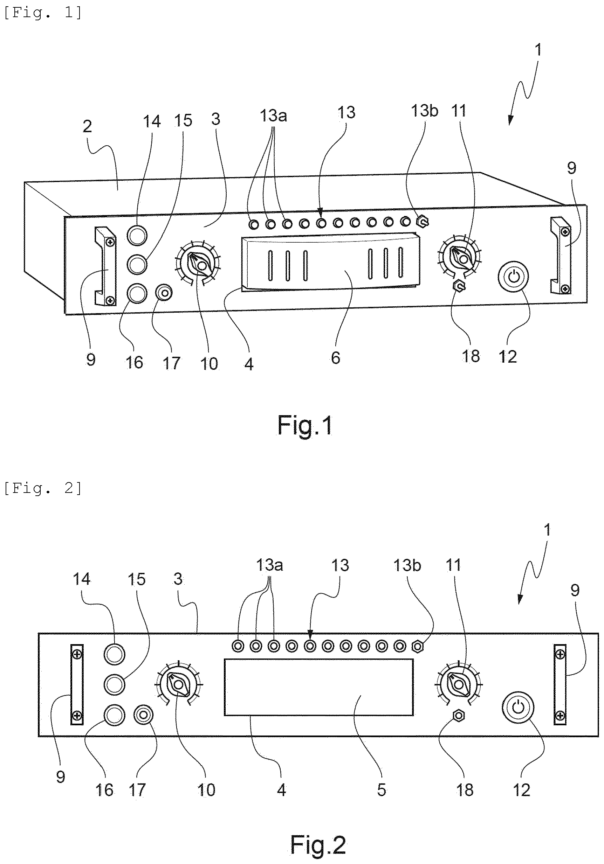

Si l'on se réfère aux Figures 1 à 3, on peut voir qu'il y est représenté un préamplificateur audio pour microphone 1 selon la présente invention.

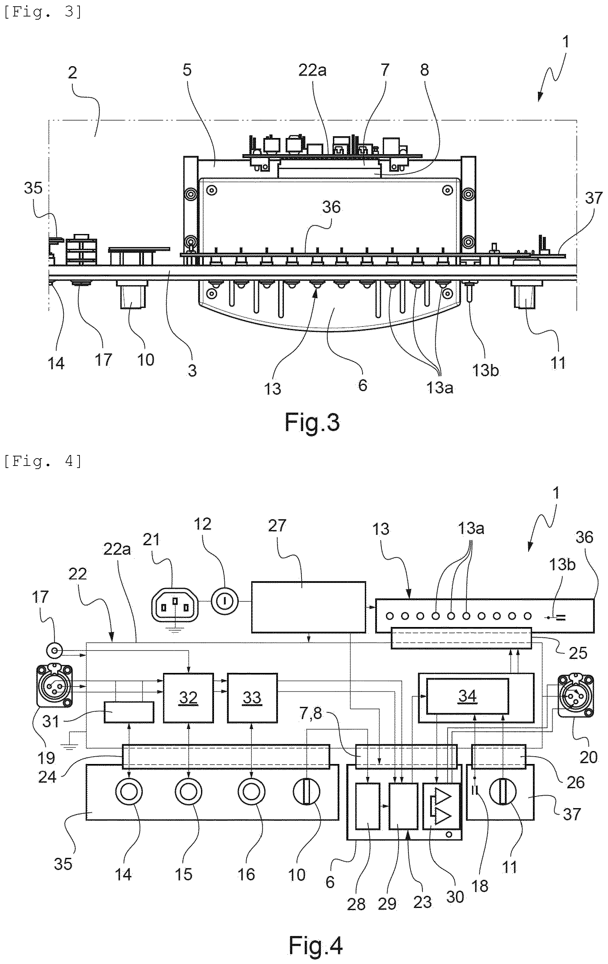

Le préamplificateur audio 1 comprend un châssis 2 de forme parallélépipédique dans lequel est disposé un premier module électronique (non visible sur les Figures 1 à 3, et qui sera décrit plus en détail à la Figure 4).

Un panneau de commande 3 est disposé en face avant du châssis 2 et possède une ouverture rectangulaire 4 depuis laquelle débouche un volume d'accueil 5 formé à l'intérieur du châssis 2.

Le préamplificateur audio 1 comprend en outre une cartouche 6, de forme sensiblement parallélépipédique, apte à être insérée de manière amovible dans le volume d'accueil 5 du châssis 2 par l'intermédiaire de l'ouverture rectangulaire 4 du panneau de commande 3.

La Figure 1 représente le préamplificateur audio 1 lorsque la cartouche 6 est insérée dans le volume d'accueil 5 du châssis, tandis que la Figure 2 représente le préamplificateur audio 1 lorsque la cartouche 6 n'est pas insérée dans le volume d'accueil 5 du châssis 2.

Comme représenté sur la Figure 3, un premier connecteur 7 est disposé au fond du volume d'accueil 5 du châssis 2, et un second connecteur 8, complémentaire du premier connecteur 7, est disposé sur la face arrière de la cartouche 6, de telle sorte que, lorsque la cartouche 6 est insérée jusqu'au fond du volume d'accueil 5 du châssis 2, les premier et second connecteurs 7 et 8 sont reliés l'un à l'autre.

Les premier 7 et second 8 connecteurs complémentaires peuvent, par exemple, être des connecteurs de type connecteur de bord de carte.

Le châssis 2 est générique et regroupe l'environnement électronique commun à tous les préamplificateurs audio. En revanche, la partie électronique de la fonction de préamplification est déportée dans la cartouche 6 qui est interchangeable.

Le volume d'accueil 5 du châssis 2 permet ainsi d'accueillir et de brancher rapidement différents types de circuits de préamplification sous forme de cartouche 6. Deux poignées 9 sont fixées par vissage de part et d'autre du panneau de commande 3, de manière à faciliter l'installation et l'extraction du préamplificateur audio 1. Le panneau de commande 3 comprend un sélecteur de gain 10, sous la forme d'un commutateur rotatif à douze positions (ou potentiomètre) correspondant respectivement à douze valeurs de gain différentes (par exemple, 0, 6, 12, 18, 24, 30, 36, 42, 48, 54, 60 et 66 dB), ce qui permet à l'utilisateur de choisir le gain du préamplificateur audio 1.

Le panneau de commande 3 comprend en outre un sélecteur de puissance de sortie 11, sous la forme d'un commutateur rotatif à douze positions correspondant respectivement à douze valeurs de puissance de sortie différentes, ce qui permet à l'utilisateur de choisir le niveau sonore du signal audio à la sortie du préamplificateur audio 1.

Le panneau de commande 3 comprend en outre un interrupteur marche/arrêt 12 qui permet à l'utilisateur de mettre sous tension/hors tension le préamplificateur audio 1.

Le panneau de commande 3 comprend en outre un vumètre 13 comprenant dix diodes électroluminescentes 13a, de manière à indiquer visuellement à l'utilisateur le niveau sonore du signal audio de sortie du préamplificateur audio 1. Avantageusement, les dix diodes électroluminescentes (DEL) comprennent six DEL vertes (correspondant respectivement à des niveaux sonores de -20 dB, -10 dB, -7 dB, -5 dB, -3 dB et -1 dB), une DEL jaune (correspondant à un niveau sonore de 0 dB) et trois DEL rouges (correspondant respectivement à des niveaux sonores de +1 dB, +2 dB et +3 dB).

Le vumètre 13 comprend en outre un interrupteur 13b qui permet à l'utilisateur de choisir si le vumètre 13 représente visuellement le niveau sonore avant ou après passage du signal audio préamplifié dans un circuit de réglage de puissance de sortie relié au sélecteur de puissance de sortie 11.

Le panneau de commande 3 comprend en outre un commutateur d'activation d'alimentation fantôme 48V 14, un commutateur d'activation d'inversion de phase 15, un commutateur d'activation de bloc d'atténuation -20dB 16 et un commutateur d'activation de filtre passe-haut 18.

Avantageusement, chacun des commutateurs 14, 15, 16 sont de type bouton-poussoir et intègre un voyant lumineux pour indiquer l'état du commutateur à l'utilisateur.

Le panneau de commande 3 comprend en outre une entrée audio de type jack 17.

Si l'on se réfère à la Figure 4, on peut voir qu'il y est représenté le schéma de principe du préamplificateur audio 1 selon la présente invention.

Outre l'entrée audio de type jack 17, le préamplificateur audio 1 comprend en outre une entrée audio de type XLR 19 et une sortie audio de type XLR 20 toutes les deux disposées sur la face arrière du châssis 2.

L'entrée audio de type jack 17 comprend un pôle positif et une masse et permet la transmission d'un signal dit asymétrique, tandis que l'entrée audio de type XLR 19 et la sortie audio de type XLR 20 comprennent chacune un pôle positif, un pôle négatif et une masse et permettent la transmission d'un signal dit symétrique.

Le préamplificateur audio 1 comprend également une entrée d'alimentation électrique 21 de type 115/230VAC, 50/60Hz disposée sur la face arrière du châssis 2.

Un premier module électronique 22 relié au premier connecteur 7 est disposé sur une carte principale 22a dans le châssis 2 du préamplificateur audio 1, et un second module électronique 23 relié au second connecteur 8 est disposé dans la cartouche 6.

Lorsque la cartouche 6 est insérée dans le volume d'accueil 5 du châssis 2, les premier et second connecteurs 7 et 8 sont reliés l'un à l'autre, de telle sorte que le second module électronique 23 est relié au premier module électronique 22 par l'intermédiaire des premier et second connecteurs 7 et 8.

Le sélecteur de gain 10 et les trois commutateurs 14, 15 et 16 sont montés sur une première carte de panneau de commande 35.

Les DEL 13a et l'interrupteur 13b du vumètre 13 sont montés sur une deuxième carte de panneau de commande 36.

Le sélecteur de puissance de sortie 11 et le commutateur d'activation de filtre passe-haut 18 sont montés sur une troisième carte de panneau de commande 37.

Le premier module électronique 22 est directement relié à l'entrée audio jack 17, à l'entrée audio XLR 19 et à la sortie audio XLR 20. Le premier module électronique 22 est également relié au sélecteur de gain 10 et aux commutateurs 14, 15 et 16 par l'intermédiaire d'une première nappe de liaison 24. Le premier module électronique 22 est en outre relié au vumètre 13 par l'intermédiaire d'une deuxième nappe de liaison 25, et au sélecteur de puissance de sortie 11 et au commutateur 18 par l'intermédiaire d'une troisième nappe de liaison 26.

L'entrée d'alimentation électrique 21 est reliée, par l'intermédiaire de l'interrupteur marche/arrêt 12, à une alimentation 27 de type AC/AC et AC/DC 48VDC, +/-12VDC, 36VAC, disposée dans le châssis 2 et reliée au premier module électronique 22, au second module électronique 23 par l'intermédiaire des premier et second connecteurs 7 et 8, et au vumètre 13, de manière à alimenter en puissance ces différents composants lorsque l'interrupteur marche/arrêt 12 est en position marche.

Le second module électronique 23 de la cartouche 6 comprend un circuit de réglage de gain 28, un circuit de préamplification 29 et un circuit de désymétrisation/symétrisation 30.

Le premier module électronique 22 du châssis 2 comprend un circuit d'alimentation fantôme 48V 31 relié au commutateur d'activation d'alimentation fantôme 48V 14 par l'intermédiaire de la première nappe de liaison 24 et à l'entrée audio de type XLR 19, de telle sorte que, lorsque le commutateur 14 est actionné par l'utilisateur, le circuit d'alimentation fantôme 48V 31 est configuré pour fournir une tension fantôme 48V à l'entrée audio XLR 19 pour alimenter un microphone branché sur cette dernière.

Le premier module électronique 22 comprend en outre un circuit d'inversion de phase 32 relié directement à l'entrée audio jack 17 et à l'entrée audio XLR 19, et relié au commutateur d'activation d'inversion de phase 15 par l'intermédiaire de la première nappe de liaison 24. Le circuit d'inversion de phase 32 est configuré pour réaliser une commutation automatique jack/XLR en fonction de l'entrée audio utilisée et pour symétriser le signal audio d'entrée lorsque celui-ci provient de l'entrée audio jack 17. Le circuit d'inversion de phase 32 est également configuré pour inverser la phase du signal audio d'entrée lorsque le commutateur d'activation d'inversion de phase 15 est actionné. Le circuit d'inversion de phase 32 intègre en outre un filtre de compatibilité électromagnétique (CEM). Le premier module électronique 22 comprend en outre un circuit de bloc d'atténuation -20dB 33 dont l'entrée symétrique est reliée à la sortie symétrique du circuit d'inversion de phase 32. Le circuit de bloc d'atténuation - 20dB 33 est en outre relié au commutateur d'activation de bloc d'atténuation -20dB 16 par l'intermédiaire de la première nappe de liaison et est configuré pour atténuer le signal audio d'entrée de -20dB lorsque le commutateur d'activation de bloc d'atténuation -20dB 16 est actionné. La sortie symétrique du circuit de bloc d'atténuation -20dB 33 est reliée à l'entrée symétrique du circuit de préamplification 29 du second module électronique 23 de la cartouche 6 par l'intermédiaire des premier et second connecteurs 7 et 8.

Le premier module électronique 22 est également configuré pour transmettre un signal de sélection de gain, provenant du sélecteur de gain 10, au circuit de réglage de gain 28 du second module électronique 23 de la cartouche 6, le circuit de réglage de gain 28 étant configuré pour régler le gain du circuit de préamplification 29 de la cartouche 6 en fonction dudit signal de sélection de gain reçu.

Le circuit de préamplification 29 est configuré pour préamplifier le signal audio symétrique provenant du circuit de bloc d'atténuation -20dB 33 en un signal audio préamplifié symétrique, puis le signal audio préamplifié symétrique est désymétrisé par le circuit de désymétrisation du circuit de désymétrisation/symétrisation 30 en un signal audio préamplifié asymétrique puis transmis, par l'intermédiaire des premier et second connecteurs 7 et 8, à un circuit de réglage de puissance de sortie 34 du premier module électronique 22.

Le circuit de réglage de puissance de sortie 34 du premier module électronique 22 est configuré pour régler la puissance de sortie du signal audio préamplifié asymétrique en fonction d'un signal de sélection de puissance de sortie provenant du sélecteur de puissance de sortie 11.

Le circuit de réglage de puissance de sortie 34 comprend en outre un circuit d'adaptation d'impédance et un filtre actif passe-haut de -12 dB/octave configuré pour être activé par le commutateur d'activation de filtre passe-haut 18 qui possède trois positions possibles : Fréquence de coupure de 80Hz ; Arrêt ; et Fréquence de coupure de 120Hz. L'entrée et la sortie du circuit de réglage de puissance de sortie 34 sont reliées au vumètre 13 par l'intermédiaire de la deuxième nappe de liaison 25, l'interrupteur 13b du vumètre 13 permettant à l'utilisateur de choisir si le vumètre 13 représente visuellement le niveau sonore avant ou après passage du signal audio préamplifié dans le circuit de réglage de puissance de sortie 34.

Le signal audio asymétrique en sortie du circuit de réglage de puissance de sortie 34 est ensuite transmis au circuit de désymétrisation/symétrisation 30 dont le circuit de symétrisation permet de resymétriser le signal audio avant de le transmettre à la sortie audio XLR 20 par l'intermédiaire des deux connecteurs 7 et 8 et du premier module électronique 22.

La cartouche 6 est métallique de manière à servir de cage de Faraday, la présence du signal basse fréquence dans la cartouche 6 de type cage de Faraday permettant ainsi d'obtenir un résultat de compatibilité électromagnétique (CEM) optimal.

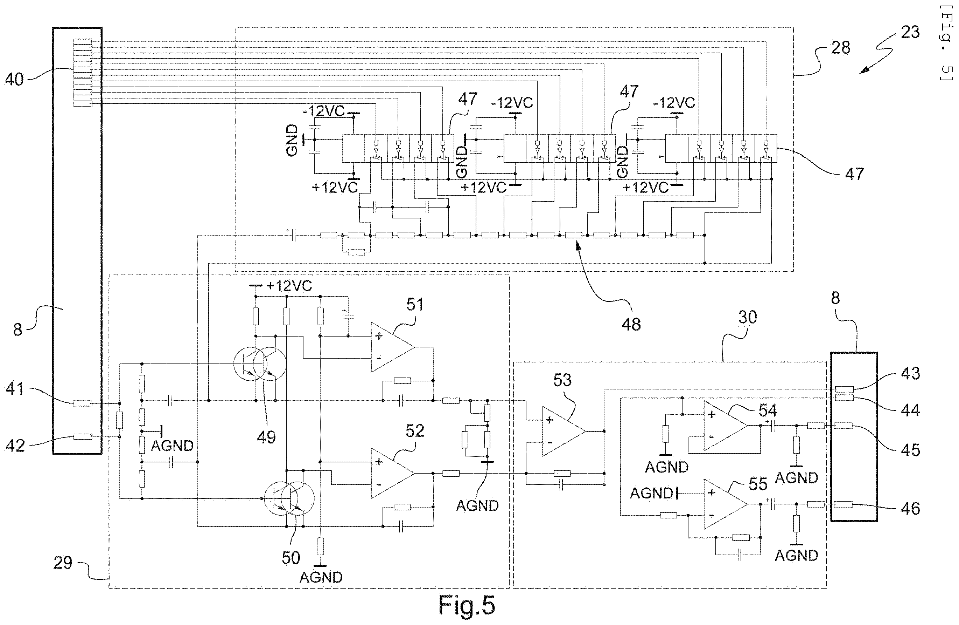

Si l'on se réfère à la Figure 5, on peut voir qu'il y est représenté un agencement à titre d'exemple du second module électronique 23 de la cartouche 6 du préamplificateur audio 1.

Le second connecteur 8 comprend une borne d'entrée de signal de sélection de gain à 12 bits 40, deux bornes d'entrée de signal audio symétrique à préamplifier 41 et 42, une borne de sortie de signal audio préamplifié asymétrique 43, une borne d'entrée de signal audio préamplifié asymétrique réglé en puissance de sortie 44 et deux bornes de sortie de signal audio préamplifié symétrique réglé en puissance de sortie 45 et 46.

Le circuit de réglage de gain 28 comprend un réseau de douze commutateurs analogiques 47 dont les entrées numériques de commande sont reliées à la borne d'entrée de signal de sélection de gain à 12 bits 40. Lorsque la cartouche 6 est montée dans le châssis 2, chacun des douze commutateurs analogiques 47 est relié à l'un des douze bits du signal de sélection de gain provenant du sélecteur de gain 10 du panneau de commande 3.

Le circuit de réglage de gain 28 comprend en outre un réseau de résistances 48 relié au réseau de commutateurs analogiques 47, le pilotage du réseau de commutateurs analogiques 47 par le signal de sélection de gain permettant de changer la valeur ohmique globale du réseau de résistances 48 en fonction du signal de sélection de gain, c'est-à-dire en fonction de la position du sélecteur de gain 10.

Chacune des douze positions du sélecteur de gain 10 correspond à une valeur ohmique différente du réseau de résistances 48 du circuit de réglage de gain 28.

Le réseau de résistances 48 est relié au circuit de préamplification 29 de manière à modifier le gain du circuit de préamplification 29 en fonction de la valeur ohmique du réseau de résistances 48 définie par la position du sélecteur de gain 10.

Le circuit de préamplification 29 comprend une première paire de transistors de puissance en parallèle 49 dont les grilles sont reliées à l'une 41 des deux bornes d'entrée de signal audio symétrique à préamplifier 41 et 42, et une seconde paire de transistors de puissance en parallèle 50 dont les grilles sont reliées à l'autre 42 des deux bornes d'entrée de signal audio symétrique à préamplifier 41 et 42.

Le circuit de préamplification 29 comprend en outre un premier amplificateur opérationnel 51 dont l'entrée négative est reliée aux drains de la première paire de transistors 49 et un deuxième amplificateur opérationnel 52 dont l'entrée négative est reliée aux drains de la seconde paire de transistors 50.

Le circuit de préamplification 29 comprend en outre plusieurs résistances et plusieurs condensateurs qui, en association avec le réseau de résistances 48 dont l'une des extrémités est reliée aux sources de la première paire de transistors 49 et dont l'autre des extrémités est reliée aux sources de la seconde paire de transistors 50, permettent de définir le gain du circuit de préamplification 29.

Le réseau de résistances 48 du circuit de réglage de gain 28 permet ainsi de reconstituer la courbe résistive de gain (par exemple, linéaire, logarithmique ou anti logarithmique, etc.) de n'importe quel préamplificateur existant (par exemple, à lampe, à amplificateur opérationnel (AOP), à transistor classe A, etc.).

En pratique, pour chaque préamplificateur audio existant, la courbe du potentiomètre est reconstituée en prélevant différentes valeurs ohmiques correspondant à l'ensemble des positions possibles du sélecteur de gain 10. L'agencement du réseau de résistances 48 et du réseau de commutateurs analogiques 47 dans le circuit de réglage de gain 28 de la cartouche 6 est ensuite choisi pour reproduire les valeurs ohmiques prélevées selon la position du sélecteur de gain 10.

La présente invention permet ainsi d'avoir un châssis 2 générique dont le panneau de commande 3 peut commander n'importe quelle conception électronique de circuit de préamplification sous forme de cartouche 6 et de conserver le signal basse fréquence de faible amplitude sur la cartouche 6.

Le circuit de désymétrisation/symétrisation 30 comprend un circuit de désymétrisation comprenant un troisième amplificateur opérationnel 53 associé à une résistance et un condensateur montés en parallèle entre la borne négative et la sortie du troisième amplificateur opérationnel 53, les entrées positive et négative du troisième amplificateur opérationnel étant respectivement reliées aux sorties positive et négative du signal audio préamplifié symétrique en sortie du circuit de préamplification 29. La sortie du troisième amplificateur opérationnel 53 est reliée à la borne de sortie de signal audio préamplifié asymétrique 43 pour être reliée au circuit de réglage de puissance de sortie 34 du châssis 2 lorsque la cartouche 6 est montée dans le châssis 2.

Le circuit de désymétrisation/symétrisation 30 comprend en outre un circuit de symétrisation comprenant un quatrième amplificateur opérationnel 54 et un cinquième amplificateur opérationnel 55 associés à des résistances et à des condensateurs. L'entrée positive du quatrième amplificateur opérationnel 54 et l'entrée négative du cinquième amplificateur opérationnel 55 sont toutes les deux reliées à la borne d'entrée de signal audio préamplifié asymétrique réglé en puissance de sortie 44 qui est reliée, lorsque la cartouche 6 est montée dans le châssis 2, à la sortie du circuit de réglage de puissance de sortie 34 du châssis 2. Les sorties des quatrième et cinquième amplificateurs opérationnels 54 et 55 constituent ainsi les sorties positive et négative du signal audio préamplifié symétrique après réglage de puissance de sortie, et sont respectivement reliées aux deux bornes de sortie de signal audio préamplifié symétrique réglé en puissance de sortie 45 et 46 pour être transmises à la sortie audio XLR 20 du châssis 2 lorsque la cartouche 6 est montée dans le châssis 2.

Il est à noter que le second module électronique 23 de la cartouche 6 pourrait également prendre un quelconque autre agencement, sans s'écarter du cadre de la présente invention, l'unique condition étant qu'il comprenne un quelconque réseau de résistances 48 associé à un quelconque réseau de commutateurs analogiques 47 ou relais pour le réglage du gain du circuit de préamplification 29 en fonction de la position du sélecteur de gain 10.

La présente invention a également pour objet un kit de préamplification audio comprenant un préamplificateur audio 1 tel que décrit ci-dessus et plusieurs cartouches supplémentaires (non représentées sur les Figures), chaque cartouche supplémentaire comprenant un circuit de préamplification 29 et un circuit de réglage de gain 28 associé à un second connecteur 8 complémentaire du premier connecteur 7 du châssis 2 du préamplificateur audio 1, chaque cartouche supplémentaire étant configurée pour être insérée seule et de manière amovible dans le volume d'accueil 5 du châssis 2 de manière à connecter les premier et second connecteurs 7 et 8 l'un à l'autre, où deux cartouches quelconques parmi la cartouche 6 du préamplificateur audio 1 et les cartouches supplémentaires ont au moins l'un parmi des circuits de préamplification 29 différents et des circuits de réglage de gain 28 différents.

Ainsi, le volume d'accueil 5 du châssis 2 du kit de préamplification audio selon la présente invention permet l'insertion d'une seule cartouche 6 choisie en fonction de la préamplification souhaitée. La fonction de préamplification du kit peut ainsi être facilement et rapidement changée en retirant la cartouche 6 actuellement branchée et en la remplaçant par une autre cartouche du kit ayant une fonction de préamplification appropriée.

Il est bien entendu que le mode de réalisation particulier qui vient d'être décrit a été donné à titre indicatif et non limitatif, et que des modifications peuvent être apportées sans que l'on s'écarte pour autant de la présente invention.

## Revendications

1. Préamplificateur audio (1) pour microphone, **caractérisé par le fait qu'**il comprend :
un châssis (2) dans lequel est disposé un premier module électronique (22), le châssis (2) comprenant au moins une entrée audio (17, 19) et au moins une sortie audio (20) reliées au premier module électronique (22), un panneau de commande (3) comportant un sélecteur de gain (10) étant disposé sur l'une des faces du châssis (2) et relié au premier module électronique (22), le châssis (2) possédant en outre un volume d'accueil (5) à l'intérieur duquel est disposé un premier connecteur (7) relié au premier module électronique (22), le panneau de commande (3) possédant une ouverture (4) depuis laquelle débouche le volume d'accueil (5) ; et
une cartouche (6) dans laquelle est disposé un second module électronique (23) comprenant un circuit de préamplification (29) et un circuit de réglage de gain (28), la cartouche (6) possédant en outre un second connecteur (8) complémentaire du premier connecteur (7), ledit second connecteur (8) étant relié au second module électronique (23), la cartouche (6) étant configurée pour être insérée de manière amovible dans le volume d'accueil (5) du châssis (2) par l'intermédiaire de l'ouverture (4) de manière à connecter les premier et second connecteurs (7, 8) l'un à l'autre ;
dans lequel, lorsque la cartouche (6) est insérée dans le volume d'accueil (5) du châssis (2) et que les premier et second connecteurs (7, 8) sont connectés ensemble, le premier module électronique (22) est configuré pour transmettre un signal audio d'entrée, provenant de l'au moins une entrée audio (17, 19), au circuit de préamplification (29) de la cartouche (6) et un signal de sélection de gain, provenant du sélecteur de gain (10), au circuit de réglage de gain (28) de la cartouche (6), le circuit de réglage de gain (28) est configuré pour régler le gain du circuit de préamplification (29) en fonction du signal de sélection de gain, et le circuit de préamplification (29) est configuré pour préamplifier le signal audio d'entrée et transmettre le signal audio préamplifié au premier module électronique (23) qui est configuré pour le transmettre ensuite à l'au moins une sortie audio (20).

2. Préamplificateur audio (1) selon la revendication 1, **caractérisé par le fait que** le circuit de réglage de gain (28) comprend un réseau de résistances (48) relié au circuit de préamplification (29) et un réseau de commutateurs analogiques ou relais (47) reliés au réseau de résistances (48) et configurés pour être pilotés par le signal de sélection de gain de manière à changer la valeur ohmique du réseau de résistances (48) en fonction du signal de sélection de gain.

3. Préamplificateur audio (1) selon la revendication 2, **caractérisé par le fait que** le sélecteur de gain (10) est un commutateur à douze positions, les douze positions correspondant à douze valeurs ohmiques différentes du réseau de résistances (48) du circuit de réglage de gain (28).

4. Préamplificateur audio (1) selon l'une des revendications 1 à 3, **caractérisé par le fait que** le second module électronique (23) de la cartouche (6) comprend en outre, en aval du circuit de préamplification (29), un circuit de désymétrisation et un circuit de symétrisation (30).

5. Préamplificateur audio (1) selon l'une des revendications 1 à 4, **caractérisé par le fait que** la cartouche (6) est métallique de manière à servir de cage de Faraday.

6. Préamplificateur audio (1) selon l'une des revendications 1 à 5, **caractérisé par le fait que** l'au moins une entrée audio (17, 19) et l'au moins une sortie audio (20) sont d'au moins un type parmi jack et XLR.

7. Préamplificateur audio (1) selon l'une des revendications 1 à 6, **caractérisé par le fait que** le panneau de commande (3) comprend en outre un vumètre (13) relié au premier module électronique (22).

8. Préamplificateur audio (1) selon l'une des revendications 1 à 7, **caractérisé par le fait que** le châssis (2) comprend en outre une entrée d'alimentation électrique (21) reliée au premier module électronique (22) et au premier connecteur (7) par l'intermédiaire d'un interrupteur marche/arrêt (12) disposé sur le panneau de commande (3).

9. Préamplificateur audio (1) selon l'une des revendications 1 à 8, **caractérisé par le fait que** le premier module électronique (22) comprend un circuit de réglage de puissance de sortie (34) configuré pour régler la puissance de sortie du signal audio préamplifié en fonction d'un signal de sélection de puissance de sortie provenant d'un sélecteur de puissance de sortie (11) disposé sur le panneau de commande (3).

10. Préamplificateur audio (1) selon la revendication 9, **caractérisé par le fait que** le circuit de réglage de puissance de sortie (34) comprend en outre un filtre passe-haut configuré pour être activé par un commutateur d'activation de filtre passe-haut (18) disposé sur le panneau de commande (3).

11. Préamplificateur audio (1) selon l'une des revendications 1 à 10, **caractérisé par le fait que** le premier module électronique (22) comprend un circuit d'alimentation fantôme 48V (31) en aval d'une entrée audio de type XLR (19), ledit circuit d'alimentation fantôme 48V (31) étant configuré pour être actionné par un commutateur d'activation d'alimentation fantôme 48V (14) disposé sur le panneau de commande (3).

12. Préamplificateur audio (1) selon l'une des revendications 1 à 11, **caractérisé par le fait que** le premier module électronique (22) comprend un circuit d'inversion de phase (32) disposé entre l'au moins une entrée audio (17, 19) et le premier connecteur (7), ledit circuit d'inversion de phase (32) étant configuré pour être activé par un commutateur d'activation d'inversion de phase (15) disposé sur le panneau de commande (3).

13. Préamplificateur audio (1) selon l'une des revendications 1 à 12, **caractérisé par le fait que** le premier module électronique (22) comprend un circuit de bloc d'atténuation -20dB (33) disposé entre l'au moins une entrée audio (17, 19) et le premier connecteur (7), ledit circuit de bloc d'atténuation -20dB (33) étant configuré pour être activé par un commutateur d'activation de bloc d'atténuation -20dB (16) disposé sur le panneau de commande (3) .

14. Kit de préamplification audio comprenant un préamplificateur audio (1) selon l'une des revendications 1 à 13 et plusieurs cartouches supplémentaires, chaque cartouche supplémentaire comprenant un circuit de préamplification (29) et un circuit de réglage de gain (28) reliés à un second connecteur (8) complémentaire du premier connecteur (7) du châssis (2) du préamplificateur audio (1), chaque cartouche supplémentaire étant configurée pour être insérée seule et de manière amovible dans le volume d'accueil (5) du châssis (2) de manière à connecter les premier et second connecteurs (7, 8) l'un à l'autre, dans lequel deux cartouches quelconques parmi la cartouche (6) du préamplificateur audio (1) et les cartouches supplémentaires ont au moins l'un parmi des circuits de préamplification (29) différents et des circuits de réglage de gain (28) différents.
